## Europäisches Patentamt
## European Patent Office
## Office européen des brevets

(11) Veröffentlichungsnummer: **0 451 620 A2**

(12) **EUROPÄISCHE PATENTANMELDUNG**

(21) Anmeldenummer: **91104848.6**

(22) Anmeldetag: **27.03.91**

(51) Int. Cl.5: **H03G 5/16**

(30) Priorität: **11.04.90 DE 4011704**

(43) Veröffentlichungstag der Anmeldung:
**16.10.91 Patentblatt 91/42**

(84) Benannte Vertragsstaaten:
**AT DE FR IT**

(71) Anmelder: **Blaupunkt-Werke GmbH**
**Robert-Bosch-Strasse 200**
**W-3200 Hildesheim(DE)**

(72) Erfinder: **Aust, Hans-Ulrich, Dr.**
**Am Nottbohm 8**
**W-3200 Hildesheim(DE)**

(74) Vertreter: **Eilers, Norbert, Dipl.-Phys.**
**Robert-Bosch-Strasse 200**
**W-3200 Hildesheim(DE)**

(54) **Anordnung zur Verbesserung der Wiedergabe-Qualität von Audiosignalen.**

(57) Bei einer Anordnung zur Verbesserung der Wiedergabe-Qualität von Audiosignalen im Fahrgastraum eines Kraftfahrzeugs, ist ein Filter mit steuerbarem Frequenzgang für die Audiosignale angeordnet, zu dessen Steuerung Mittel zur Erzeugung, Wiedergabe, Aufnahme und Auswertung von Meßsignalen vorgesehen sind. In einer Wiedergabe-Betriebsart werden von einer Audiosignalquelle erzeugte Audiosignale wiedergegeben. In einer Adaptions-Betriebsart werden nacheinander Meßsignale verschiedener Frequenzen wiedergegeben, über ein im Fahrgastraum angeordnetes Mikrofon aufgenommen und zur Steuerung des Frequenzgangs des Filters ausgewertet.

Die Erfindung geht aus von einer Anordnung nach der Gattung des Hauptanspruchs.

Die Übertragungsfunktion zwischen der Verstärkerendstufe einer Audio-Wiedergabeeinrichtung und dem Ohr des Zuhörers ist weitgehend frequenzabhängig. Diese Frequenzabhängigkeit wird einerseits durch die Qualität der Lautsprecher und andererseits durch die Beschaffenheit des umgebenden Raums bestimmt. Insbesondere bei einem Fahrgastraum eines Kraftfahrzeugs ist die Frequenzabhängigkeit veränderlich, beispielsweise in Abhängigkeit von der Zahl der Fahrgäste. Auch bei einem Austausch der Lautsprecher verändert sich die Frequenzabhängigkeit.

Aufgabe der vorliegenden Erfindung ist es, die. Wiedergabe-Qualität in einem Fahrgastraum eines Kraftfahrzeugs weitgehend unabhängig von der Beschaffenheit des Fahrgastraums zu verbessern.

Die erfindungsgemäße Anordnung mit den kennzeichnenden Merkmalen des Hauptanspruchs hat den Vorteil, daß eine Audio-Wiedergabeeinheit - beispielsweise ein Autoradio, ein Kassetten- oder CD-Wiedergabegerät - automatisch an die möglicherweise wechselnde Beschaffenheit des Fahrgastraums, insbesondere an die Zahl der Fahrgäste, angepaßt wird.

Der Betrag der Übertragungsfunktion $H(f)$ besteht üblicherweise aus zwei Anteilen:

1. einem "weichen" Verlauf mit betragsmäßig kleinem $\delta H(f)/\delta f$ und diesem überlagert
2. einem aus vielen, scharf ausgeprägten Maxima und Minima bestehenden Verlauf.

Der zweite Anteil wird stark durch Resonanzen in der Fahrgastzelle geprägt und ist je nach Wellenlänge stark ortsabhängig. Bei geringfügiger Veränderung der Zuhörerposition um wenige cm können sich die Beträge der Maxima und Minima drastisch verändern.

Die vorliegende Erfindung befaßt sich mit dem für den Höreindruck wichtigeren ersten Anteil. Wegen des relativ "weichen" Verlaufs läßt sich der Betrag der Übertragungsfunktion $|H^{-1}(f)|$ durch ein Filter niedriger Ordnung darstellen.

Durch die in den Unteransprüchen aufgeführten Maßnahmen sind vorteilhafte Weiterbildungen und Verbesserungen der im Hauptanspruch angegebenen Erfindung möglich.

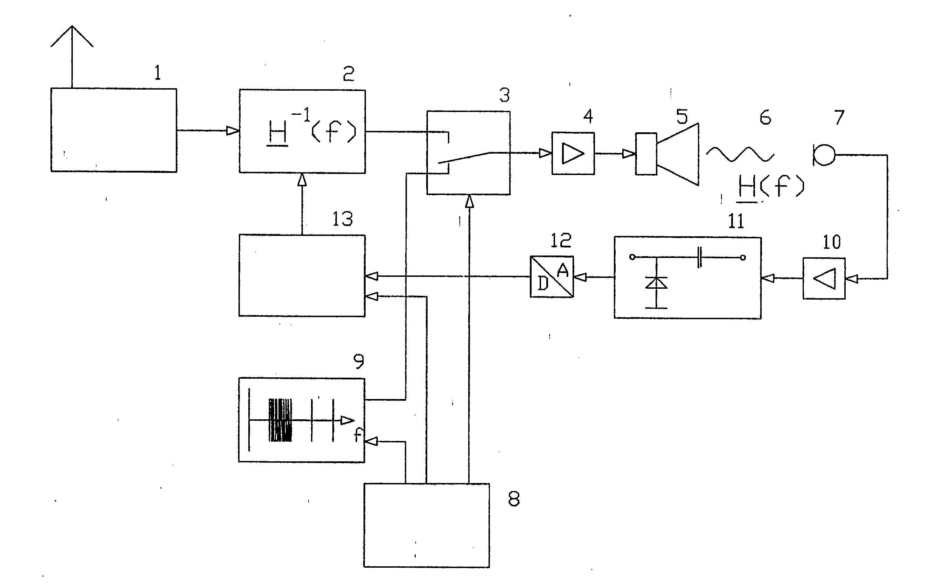

Ein Ausführungsbeispiel der Erfindung ist in der Zeichnung dargestellt und in der nachfolgenden Beschreibung näher erläutert.

Bei dem als Blockschaltbild dargestellten Ausführungsbeispiel ist als Audiosignalquelle 1 das Empfangsteil eines Autoradios vorgesehen. Es eignen sich jedoch auch andere Audiosignalquellen, wie beispielsweise Magnetbandwiedergabegeräte. Die digitalen Ausgangssignale der Audiosignalquelle 1 werden über ein steuerbares Filter 2, einen Umschalter 3 und einen Verstärker 4 einem Lautsprecher 5 zugeführt, der entsprechende Schallwellen in den Fahrgastraum 6 des nicht dargestellten Kraftfahrzeugs abstrahlt. Die Übertragungsfunktion zwischen dem Lautsprecher 5 und einem Mikrofon 7 ist $H(f)$. Das Ziel der erfindungsgemäßen Anordnung ist es nunmehr, das Filter 2 mit einem inversen Frequenzgang $H^{-1}(f)$ zu versehen, damit bis zum Mikrofon 7 bzw. bis zu einem im Fahrgastraum befindlichen Zuhörer der Frequenzgang möglichst eben ist.

Zur Steuerung des Frequenzgangs $H^{-1}(f)$ des Filters 2 wird die dargestellte Anordnung von einem Steuerwerk 8 aus einer Wiedergabe-Betriebsart in eine Adaptions-Betriebsart geschaltet. Dieses erfolgt vorzugsweise bei stehendem Fahrzeug, damit die Meßergebnisse nicht durch Fahrgeräusche verfälscht werden. Dazu wird der Umschalter 3 von der oberen in die untere Stellung gebracht. Dann wird mit Hilfe eines Rauschgenerators 9 ein schmalbandiges Rauschsignal auf den Lautsprecher 5 gegeben. Das vom Lautsprecher 5 abgestrahlte und durch den Fahrgastraum 6 übertragene Rauschen wird vom Mikrofon 7 aufgenommen. Die Ausgangssignale des Mikrofons 7 werden in einem Verstärker 10 verstärkt und bei 11 hüllkurvendemoduliert.

Die somit erhaltene jeweilige Amplitude wird mit Hilfe eines Analog/Digital-Wandlers 12 in ein entsprechendes digitales Signal umgewandelt. Dieses wird einem Rechenwerk 13 zugeführt. Durch schrittweise Veränderung der Bandgrenzen des Rauschens wird ein dem Betrag der geglätteten Übertragungsfunktion entsprechender Kurvenverlauf über den gesamten Audiofrequenzbereich abgetastet. Bei mehreren Audiokanälen wird je Kanal ein Kurvenverlauf ermittelt.

Durch die Verwendung des Rauschsignals, welches einen definierten Frequenzbereich umfaßt, erfolgt eine Mittelung der eingangs unter 2. genannten scharf ausgeprägten Maxima und Minima der Übertragungsfunktion. Bei einer alternativ möglichen Verwendung von monofrequenten Meßsignalen kann die Mittelung im Rechenwerk erfolgen.

Im Anschluß an den Meßvorgang werden die Filterkoeffizienten für das digitale Filter 2 im Rechenwerk berechnet und geladen. Zur Erläuterung des Rechenvorgangs wird von einem Filter ausgegangen mit der Form:

$$(1) \qquad \underline{H}^{-1}(\underline{z}) = \sum_{k=0}^{M} \frac{a_{k1} + a_{k2}\underline{z}^{-1} + a_{k3}\underline{z}^{-2}}{1 + a_{k4}\underline{z}^{-1} + a_{k5}\underline{z}^{-2}}$$

Mit Hilfe des Rechenwerks werden die Koeffizienten $a_{ki}$ derart bestimmt, daß der Betrag der Inversen $|H_{Meß}^{-1}(f)|$ des gemessenen Frequenzgangs im Frequenzbereich der Audiosignale möglichst gut approximiert wird.

Bei vorgegebener Filterstruktur und Abtastrate läßt sich die Übertragungsfunktion $H^{-1}(z)$ in den Frequenzbereich transformieren, wobei die Transformierte mit $H_T^{-1}(a_{ki}, f)$ bezeichnet wird. Im Frequenzbereich wird nun z. B. mit Hilfe des Gradientenverfahrens der Betrag der Inversen der gemessenen Übertragungsfunktion durch Variation der Koeffizienten $a_{ki}$ derart approximiert, daß folgende Bedingung gilt:

$$(2) \qquad Q = \sum_{j=1}^{N} [\, |\underline{H}_{Meß}^{-1}(f)| - |\underline{H}_T^{-1}(a_{ki}, f)| \,]^2$$

Dabei bedeutet N die Anzahl der Meßpunkte bei der Messung von $|H_{Meß}(f)|$. Die Koeffizienten $a_{ki}$ ergeben sich iterativ zu

$$(3) \qquad a_{ki(neu)} = a_{ki(alt)} - \mu \cdot \left. \frac{\delta Q}{\delta a_{ki}} \right|_{a_{ki(alt)}}$$

Dabei bedeutet $\mu$ eine Iterationskonstante. Die Iteration wird abgebrochen, wenn Q einen vorgegebenen Wert unterschreitet.

Bei dem beschriebenen Verfahren zur Bestimmung der Filterkoeffizienten wurde die Iteration im Frequenzbereich durchgeführt. Es sind jedoch auch Verfahren zur Bestimmung der Koeffizienten im z-Bereich bekannt. Hierzu wird z. B. der Betrag von $H_{Meß}(f)$ durch ein Polynom mit vorgegebener Ordnung approximiert und mit Hilfe der bilinearen Transformation in den z-Bereich transformiert. Dort werden dann wieder mit Hilfe des Gradientenverfahrens die Koeffizienten $a_{ki}$ bestimmt.

Eine vorteilhafte Realisierung des Aufführungsbeispiels kann mit Hilfe eines digitalen Signalprozessors erfolgen. Dieser kann in der Adaptions-Betriebsart die Funktionen des Umschalters 3, des Steuerwerks 8, des Rauschgenerators 9 und des Rechenwerks 13 erfüllen. In der Wiedergabe-Betriebsart dient der digitale Signalprozessor dann als steuerbares Filter 2 und als Umschalter 3 in der oberen Stellung.

## Patentansprüche

1. Anordnung zur Verbesserung der Wiedergabe-Qualität von Audiosignalen im Fahrgastraum eines Kraftfahrzeugs, dadurch gekennzeichnet, daß ein Filter mit steuerbarem Frequenzgang für die Audiosignale angeordnet ist und daß zur Steuerung des Filters Mittel zur Erzeugung, Wiedergabe, Aufnahme und Auswertung von Meßsignalen vorgesehen sind.

2. Anordnung nach Anspruch 1, gekennzeichnet durch eine Wiedergabe-Betriebsart, in welcher von einer Audiosignalquelle erzeugte Audiosignale wiedergegeben weden, und durch eine Adaptions-Betriebsart, in welcher nacheinander Meßsignale verschiedener Frequenzen wiedergegeben, über ein im Fahrgastraum angeordnetes Mikrofon aufgenommen und zur Steuerung des Frequenzgangs des Filters ausgewertet werden.

3. Anordnung nach Anspruch 2, dadurch gekennzeichnet, daß das Filter im Sinne eines zum Frequenzgang der akustischen Übertragungsstrecke zwischen einer Wiedergabe-Einrichtung und dem Mikrofon inversen Frequenzgangs steuerbar ist.

4. Anordnung nach Anspruch 2, dadurch gekennzeichnet, daß das Meßsignal jeweils von einem Rauschsignal innerhalb eines vorgegebenen Frequenzbereichs gebildet wird.

5. Anordnung nach Anspruch 2, dadurch gekennzeichnet, daß das Meßsignal monofrequent ist und nacheinander verschiedene ausgewählte Frequenzwerte annimmt.

6. Anordnung nach Anspruch 2, dadurch gekennzeichnet, daß die Adaptions-Betriebsart jeweils nach dem Einschalten automatisch eingenommen wird und daß nach der Messung des Frequenzgangs auf die Wiedergabe-Betriebsart umgeschaltet wird.

7. Anordnung nach Anspruch 2, dadurch gekennzeichnet, daß bei mehrkanaliger Wiedergabe von Audiosignalen in jedem Wiedergabekanal ein Filter mit steuerbarem Frequenzgang vorgesehen ist und daß in der Adaptions-Betriebsart die Ermittlung von Steuersignalen für die Filter in den Wiedergabekanälen nacheinander vorgenommen wird.

8. Anordnung nach Anspruch 2, dadurch gekennzeichnet, daß im Weg der Audiosignale das Filter mit steuerbarem Frequenzgang in Reihe mit einem Umschalter liegt, daß mit einem Steuereingang des Filters ein Rechenwerk verbunden ist und an einen Eingang des Umschalters ein Rauschgenerator angeschlossen ist, daß das Rechenwerk, der Rauschgenerator und der Umschalter von einem Steuerwerk steuerbar sind und daß dem Rechenwerk Signale, welche der Amplitude der aufgenommenen Meßsignale entsprechen, zuführbar sind.

EP 0 451 620 A2